# EUROPEAN PATENT APPLICATION

(11) **EP 0 629 047 A2**
(43) Date of publication of application: **14.12.1994**
(21) Application number: 94201490.3
(22) Date of filing: 26.05.1994
(51) Int. Cl.: H03K 19/094, H03K 19/0185, H03K 19/013, H03K 19/0944

(54) **Low-voltage high-current BiCMOS output circuit**

(30) Priority: 02.06.1993 US 90673
(71) Applicant: PHILIPS ELECTRONICS N.V., 5621 BA Eindhoven (NL)
(72) Inventor: Murray, Robert, c/o INT. OCTROOIBUREAU B.V., NL-5656 AA Eindhoven (NL)
(74) Representative: Strijland, Wilfred

(57) **Abstract**

A BiCMOS output circuit comprises an upper part connected to a low-voltage, e.g., 3 volt, supply and functioning to pull an output up to the supply voltage during a high-to-low input transition, a lower part connected to a reference potential such as ground and functioning to pull-down the output to the reference level during a low-to-high transition at the input, a CMOS circuit to hold the output state to the power supply, and the novel addition of a "quasi-complementary" kicker circuit to both the upper and lower parts of the circuit. The effect is to provide low voltage cells requiring less drive yet operating faster than their 5-volt counterparts.

## Description

### FIELD OF THE INVENTION

The invention relates to integrated circuits (ICs), and in particular to combined bipolar and complementary MOS (CMOS) circuits, commonly known as BiCMOS circuits.

### BACKGROUND OF THE INVENTION

A trend in IC circuits is toward low-voltage circuits which can operate directly off of two conventional batteries. A typical voltage range is 2.7-3.6 volts. Another trend is toward faster circuits. The latter has resulted in the increased popularity of BiCMOS circuits which combine the low power characteristic of a CMOS circuit and the speed characteristic of the bipolar circuit. However, lowering the normal 5-volt operating voltage to 2.7-3.6 volts inherently reduces the speed of operation.

In all of the known 2.7-3.6 volt BiCMOS output circuits, the output is typically driven by a tandem arrangement of bipolar and CMOS circuits. The bipolar output part drives the load during the typical high-to-low transition, while the CMOS part holds the output state to the power supply levels and provides all the current for the DC specifications. Some changes from the typical 5-volt IC's also include the removal of the Darlington transistors from the bipolar pull-up circuit and the new "quasi-complementary" structure that allows functionality and performance at very low supply voltages. However, when the power supply is reduced to 2.7-3.6 volts, incorporating these changes causes the bipolar transistors to be under-driven as compared to their 5-volt counterparts. The result is lower operating performance.

### OBJECT OF THE INVENTION

An object of the invention is an improved BiCMOS circuit.

A further object of the invention is a high speed BiCMOS capable of operating off of low supply voltages.

Still another object of the invention is a low voltage BiCMOS output circuit requiring less drive than, yet operating faster than, their 5-volt counterparts.

### SUMMARY OF THE INVENTION

The electronic device in the invention comprises a BiCMOS output circuit including an input, an output, first CMOS logic gate means, e.g., an inverter, connected between the input and the output, a pull-up bipolar transistor device and a pull-down bipolar transistor device interconnected via the output. The circuit further comprises pull-up control means connected between the input and a control node of the pull-up device, and pull-down control means connected between the input and a further control node of the pull-down device. The pull-up control means comprises second CMOS logic gate means, e.g., an inverter, between the input and the control node of the pull-up device. The pull-down control means comprises third CMOS logic gate means, e.g., an inverter between the input and the control node of the pull-down device. In one aspect of the invention, the pull-up control means further comprises a Kicker bipolar transistor with a main current channel connected to the control node of the pull-up device and with a base electrode coupled to the input for controlling the pull-up device in parallel to the second CMOS logic gate means.

Preferably, the pull-down control means too comprises a, second, kicker bipolar transistor with a main current channel connected to the control node of the pull-down device and with a base electrode coupled to the input for controlling the pull-down device in parallel to the third CMOS logic gate means.

Preferably, the input is connected to the base electrode of each respective one of said kicker bipolar transistors via a respective further CMOS logic gate means, e.g., an inverter.

The pull-up device is connected to a low-voltage supply, e.g., 3 volts, and functions to pull the output up to the supply voltage during a corresponding input transition. The pull-down device is connected to a reference potential such as ground and functions to pull-down the output to the reference level during a corresponding transition at the input. The first CMOS logic gate means serves to hold the output state to the power supply. An interesting feature of the invention is the "quasi-complementary" kicker circuit to the pull-up device and, preferably, to the pull-down device. By "quasi-complementary" kicker is meant the combination of a CMOS inverter driving an N-Type bipolar transistor, with the source electrode of the PMOS transistor connected to the collector of the N-Type bipolar transistor. It has certain similarities in behaviour to a PNP or P-Type bipolar transistor.

The various features of novelty which characterize the invention are pointed out with particularity in the claims annexed to and forming a part of this disclosure. For a better understanding of the invention, its operating advantages and specific objects attained by its use, reference should be had to the accompanying drawings and descriptive matter in which there are illustrated and described, by way of example, preferred embodiments of the invention.

### BRIEF DESCRIPTION OF THE DRAWINGS

In the drawings:
Fig. 1 is a typical standard prior art 3-volt BiCMOS output circuit;
Fig. 2 is a typical standard prior art 5-volt BiCMOS output circuit; and
Fig. 3 is a circuit schematic of one form of output circuit according to the invention.

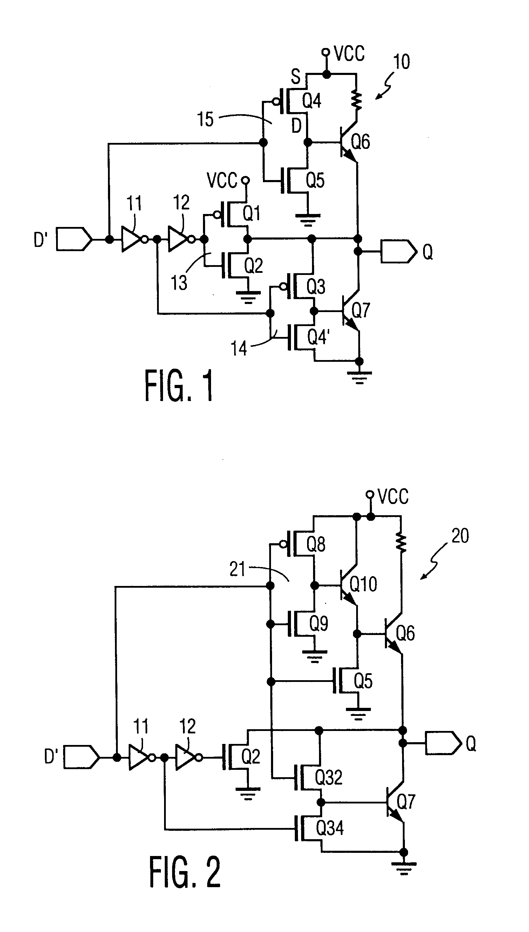

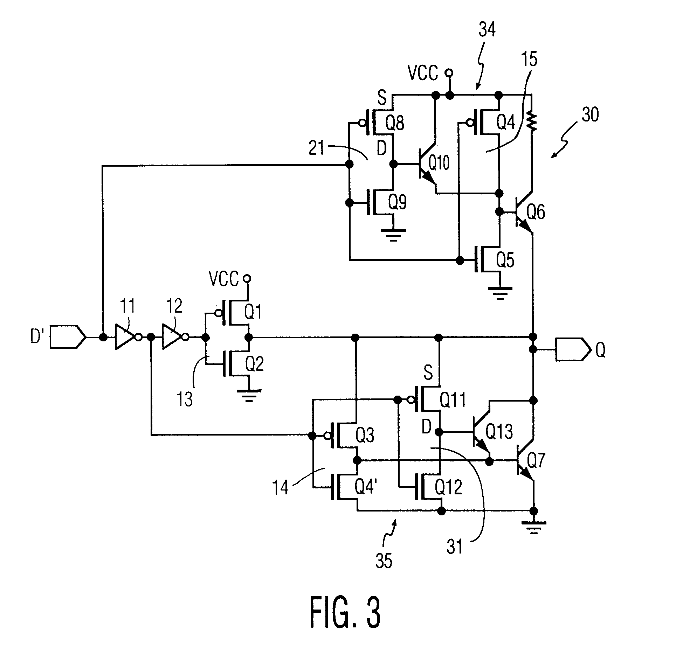

The notation used is as follows. Crossing lines do not form connections at their crossing, except where a line passes through the gate of a MOSFET or the base of a bipolar device. PMOS transistors are designated by a circle at the gate and the half- arrow gate symbol facing downward; NMOS transistors are denoted by the upward facing half arrow gate symbol. Typical CMOS inverters are shown at 13, 14, 15 in Fig. 1, at 21 in Fig. 2, and at 31 in Fig. 3. It is assumed that a value close to Vcc is a logic-high signal and a value close to ground is a logic-low signal.

Throughout the figures, the same reference numbers and letters are used to designate the same or similar functioning elements.

### DETAILED DESCRIPTION OF THE PREFERRED EMBODIMENTS

### Prior Art Standard 3-Volt BiCMOS Output Circuit

Fig. 1 represents a standard 3-volt BiCMOS output circuit 10. The output circuit 10 is an inverting block. The output load, connected to OUT, is driven high by a high-to-low signal transition on input D'. Inverters 11 and 12 supply the input transition to the CMOS drive circuit 13 which will ultimately serve to hold the OUT terminal at the power supply values of Vcc and ground.

The normal state of the circuit is with the input D' held high and the output OUT held low. When a high-to-low signal transition occurs on input D', the PMOS transistor Q4 of the upper pull-up structure starts to conduct and supplies base current to N-bipolar transistor Q6. The N-Type bipolar transistors used in the totem-pole outputs preferably are (as shown) of the Schottky type to prevent the transistors from going into deep saturation when fully on. The current supplied to the base of Q6 is multiplied by the current gain (beta) of the N-Type transistor Q6 and charges the load to about 2.2 volt. Meanwhile, PMOS transistor Q1 of the CMOS driver turns on and finishes charging of the load to Vcc (3 volt in this case).

The 3-volt circuit of Fig. 1 has the disadvantage that PMOS transistor Q4 must be very large to supply sufficient current to the base of N-Type bipolar transistor Q6 in order to effect fast switching times. This places a large burden on the driving circuit which must supply the current necessary to discharge the normally high voltage on the gate of PMOS transistor Q4. This burden is passed back through the circuit requiring the addition of several gain stages to the design to supply the necessary current.

### Prior Art Standard 5-Volt BiCMOS Output Circuit

Fig. 2 shows a standard 5-volt operating circuit, which functions similarly to that of Fig. 1, in that PMOS transistor Q8 of the pull-up inverter 21 turns on upon a high-to-low transition at the input D'. This, in turn, turns on N-Type bipolar transistor Q10 which multiplies the base drive to the output N-Type bipolar transistor Q6. As a result, much larger currents are available to the load, which translates into higher speed switching. Only an NMOS transistor Q2 is needed at the input in the 5-volt version. It will be noted that the combination of the CMOS inverter 21 and the N-Type bipolar Q10 represent a quasi-complementary kicker circuit as defined above.

The drawback, however, is that, if the 5-volt circuit of Fig. 2 were used in a 3-volt setting, the output could only be charged to 1.5 volts. This level is in the middle of the allowable threshold range and is therefore unacceptable.

### 3-Volt BiCMOS Output Circuit According To The Invention

Fig. 3 shows one form of circuit according to the invention which overcomes the drawbacks described above. This is achieved by the addition of quasi-complementary kickers to both the upper pull-up 34 and lower pull-down 35 parts of a circuit of Fig. 1. These quasi-complementary kickers are designated 21 and Q10 and 31 and Q13 in Fig. 3, respectively. They each comprise a CMOS inverter 21, 31 whose output drives the base of an N-Type bipolar transistor Q10, Q13, respectively. The output of the latter is connected to and drives the base of the respective N-Type bipolar transistor outputs Q6, Q7.

The circuit operates as follows. As before, upon the application of the high-to-low transition at input D', PMOS transistor Q4 turns on supplying drive current to the base of output N-Type bipolar transistor Q6. Meanwhile, PMOS transistor Q8 also turns on supplying base drive to N-Type bipolar transistor Q10. The base drive, when multiplied by the transistor's current gain (beta), provides an additional "kick" of high current to the base of Q6 to rapidly pull-up the output load to Vcc. When the PMOS transistor Q1 of the inverter 13 turns on, the output is held at Vcc. With the addition of the quasi-complementary Kicker, Q8, Q9, and Q10 to the Fig. 3 circuit, the size of the driving transistors Q8, Q4, Q9, and Q5 can be substantially smaller than the previous combination of Q4 and Q5 in the circuit of Fig. 1. As will be appreciated, smaller devices consume less real estate and improve yield. With the current gain of Q10, transistor Q8 in Fig. 3 looks like a much larger driver to the base of Q6. This charges the base of Q6 to 2.2 volts quickly, and then Q4 finishes the charging of the base to 3.0 volts. PMOS transistor Q1 then turns on and charges the output to Vcc, 3.0 volts.

For the low-to-high case at the input D', when the output is driven from a high to a low value for discharging of the load, the circuit of the invention proves to be very efficacious, and, surprisingly, requires less drive yet proves faster than its 5-volt counterpart. In the known 3-volt version of Fig. 1, the gate of PMOS transistor Q3 discharges and Q3 conducts to charge the base of N-Type bipolar transistor Q7. In the 5-volt version of Fig. 2, the gate of NMOS transistor Q32 charges in order to supply current to the base of Q7. In 3-volt systems, it is customary not to use the configuration in Fig. 2 for the pull-down portion since the threshold stacking effect of Q32 and Q7 tends to limit available drive at lower voltages. In the Fig. 3 circuit according to the invention, the addition of the quasi-complementary kicker circuit to the pull-down portion allows the current multiplication effect of the bipolar transistor to achieve faster charging times in the base of the output circuit. Thus, as the gate of PMOS transistor Q11 is discharged, current supplied to the base of N-Type bipolar transistor Q13 is multiplied by the current gain (beta) and sent to the base of N-Type bipolar output transistor Q7. This supplies a very large discharge current to the load and effects a quick discharge. As the load voltage drops, the bipolar transistors cut off, and the CMOS output transistor Q1 eventually assumes the burden of driving the load as it turns on during the next high-to-low transition.

The main advantage of the invention is that low voltage (2.7-3.6 volt), e.g., 3 volt, output cells can be designed that require less drive, and are faster than their 5-volt counterparts.

While the invention has been described in connection with preferred embodiments, it will be understood that modifications thereof within the principles outlined above will be evident to those skilled in the art and thus the invention is not limited to the preferred embodiments but is intended to encompass such modifications.

## Claims

1. An electronic device comprising a BiCMOS output circuit, the circuit including an input (IN), an output (OUT), first CMOS logic gate means (13) connected between the input and the output, a pull-up bipolar transistor device (Q6) and a pull-down bipolar transistor device (Q7) interconnected via the output, pull-up control means (Q4, Q5, 21, Q10) connected between the input and a control node of the pull-up device, and pull-down control means (Q3, Q4', 31, Q13) connected between the input and a further control node of the pull-down device, wherein the pull-up control means comprises second CMOS logic gate means (15) between the input and the control node of the pull-up device, and wherein the pull-down control means comprises third CMOS logic gate means (14) between the input and the control node of the pull-down device, characterized in that the pull-up control means further comprises a kicker bipolar transistor (Q10) with a main current channel connected to the control node of the pull-up device and with a base electrode coupled to the input for controlling the pull-up device in parallel to the second CMOS logic gate means.

2. The electronic device of claim 1, wherein the pull-down control means further comprises a second kicker bipolar transistor (Q13) with a main current channel connected to the control node of the pull-down device and with a base electrode coupled to the input for controlling the pull-down device in parallel to the third CMOS logic gate means.

3. The electronic device of claim 1 or 2, wherein the input is connected to the base electrode of each respective one of said kicker bipolar transistors via a respective further CMOS logic gate means (21; 31).

4. The electronic circuit of claim 1 or 2, wherein each respective one of said CMOS logic gate means comprises a respective CMOS inverter.

5. The electronic circuit of claim 3, wherein each respective one of said further CMOS logic gate means comprises a respective further CMOS inverter.

6. The electronic circuit of claim 1 or 2, being suitable for functional operation with a supply voltage substantially lower than 5 volts.
